(19) Europäisches Patentamt
European Patent Office
Office européen des brevets

(11) EP 3 163 332 B1

(12) **EUROPEAN PATENT SPECIFICATION**

(45) Date of publication and mention of the grant of the patent:
**06.03.2019 Bulletin 2019/10**

(21) Application number: **15814487.3**

(22) Date of filing: **29.06.2015**

(51) Int Cl.:
***G02B 5/08*** (2006.01)
***C08G 69/26*** (2006.01)
***C08L 77/00*** (2006.01)
***C08G 63/183*** (2006.01)
***C08G 63/199*** (2006.01)
***C08L 67/02*** (2006.01)
***H01L 33/60*** (2010.01)
***C08K 3/22*** (2006.01)

(86) International application number:
**PCT/JP2015/003259**

(87) International publication number:
**WO 2016/002192 (07.01.2016 Gazette 2016/01)**

(54) **RESIN COMPOSITION FOR REFLECTIVE MATERIAL, AND REFLECTIVE PANEL INCLUDING SAME**

HARZZUSAMMENSETZUNG FÜR REFLEKTIERENDES MATERIAL UND REFLEKTIERENDE TAFEL DAMIT

COMPOSITION DE RÉSINE POUR MATÉRIAU RÉFLÉCHISSANT, ET PANNEAU RÉFLÉCHISSANT LA COMPRENANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.06.2014 JP 2014134749**

(43) Date of publication of application:
**03.05.2017 Bulletin 2017/18**

(73) Proprietor: **Mitsui Chemicals, Inc.**
**Minato-ku**
**Tokyo 105-7122 (JP)**

(72) Inventors:
- **OHSHIMIZU, Kaoru**
  **Chiba 299-0265 (JP)**
- **OGASAWARA, Hideto**
  **Chiba 299-0265 (JP)**
- **EBATA, Hiroki**
  **Chiba 299-0265 (JP)**
- **HAMA, Takashi**
  **Chiba 299-0265 (JP)**

(74) Representative: **Hoffmann Eitle**
**Patent- und Rechtsanwälte PartmbB**
**Arabellastraße 30**
**81925 München (DE)**

(56) References cited:
**EP-A1- 3 162 852**
**WO-A1-2013/111808**
**JP-A- 2009 507 990**
**US-A- 4 355 080**
**WO-A1-2007/069760**
**JP-A- 2004 317 818**
**JP-A- 2013 067 786**
**US-A1- 2013 158 184**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

**Description**

Technical Field

The present invention relates to a resin composition for a reflective material and a reflector containing the same.

Background Art

Light sources such as light-emitting diodes (LEDs) and organic ELs have been widely used as illumination, backlights of displays, and the like by making the best use of their characteristic features such as low power consumption and long life. For efficient utilization of light from these light sources, reflectors have been used in various situations.
For example, an LED package may be configured mainly from a housing composed of a substrate and a reflector integrally molded therewith, an LED disposed inside the housing, and a transparent sealing member sealing the LED. Such an LED package may be produced by the following steps: obtaining a housing composed of a reflector molded on a substrate; disposing an LED inside the housing and electrically connecting the LED with the substrate; and sealing the LED with a sealant. During the sealing, the LED package is heated at 100 to 200 °C for thermally curing the sealant, and therefore, reflectors need to maintain their reflectance even under such heating conditions. Further, during reflow soldering for mounting the LED package on a printed substrate, the LED package is exposed to a high temperature which is 250 °C or higher, and therefore, reflectors need to also maintain their reflectance under such an even higher temperature. Furthermore, under the operating environment, reflectors need to maintain their reflectance even after exposure to heat and light generated from LEDs.
As the materials for such reflectors, use of semi-aromatic polyamides are under consideration, and such semi-aromatic polyamides include PA9T having a diamine unit containing 1,9-nonanediamine as a main component thereof, and PA10T having a diamine unit containing 1,10-decanediamine as a main component thereof. For example, resin compositions containing PA9T or PA10T, titanium oxide, a reinforcing material, a light stabilizer, an antioxidant, and a release agent are disclosed (PTLs 1 and 2). As a resin composition which can be suitably used for a reflector of an LED or the like, there is proposed a resin composition for a reflector which contains a specific polyester, a light stabilizer and/or an antioxidant (PTL 3 and 4).

Citation List

Patent Literature

PTL 1 Japanese Patent Application Laid-Open No. 2004-75994PTL 2 Japanese Patent Application Laid-Open No. 2013-67786
PTL 3 Japanese Patent Application Laid-Open No. 2013-127067
PTL 4 US 2013/0158184 A1

Summary of Invention

Technical Problem

Molded products obtained from compositions described in PTLs 1 and 2 which contain a semi-aromatic polyamide resin or heat-resistant polyester resin were incapable of satisfactorily suppressing discoloration upon exposure to heat and/or light. Accordingly, there is a demand for lower discoloration and smaller reduction of reflectance even under heat during the production or mounting of an LED package, or upon exposure to heat and light from a light source under the operating environment.
Further, in accordance with increase in luminescence of LEDs, there is a demand for, for example, further improvements in both whiteness and reflectance of reflectors used for LEDs or the like.
The present invention has been made under the above circumstances, and an object of the present invention is to provide a resin composition which enables a production of a reflector having high reflectance, together with smaller reduction of reflectance even after exposure to heat during production of a LED package or reflow soldering at the time of mounting, or to heat and light generated from a light source under the operating environment.

Solution to Problem

[1] A resin composition for a reflective material, comprising: 45 to 80 mass% of thermoplastic resin (A) having a melting point (Tm) or a glass transition temperature (Tg) of 250 °C or higher as measured by means of a differential scanning calorimeter (DSC) in accordance with JIS-K7121, the thermoplastic resin (A) being composed of at least one member selected from the group consisting of polyester resin (A1) and polyamide resin (A2); 17 to 54.99 mass% of white pigment (B); and 0.01 to 3 mass% of compound (C), the compound (C) being at least one type of a compound represented by following general formula (1):

General Formula (1)

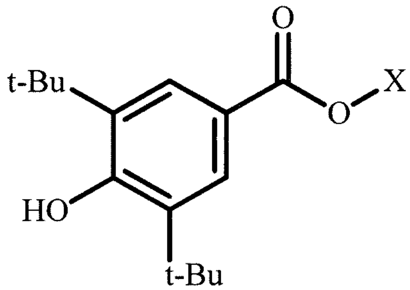

wherein X represents an organic group, total of components (A), (B) and (C) being 100 mass%.

[2] The resin composition for a reflective material according to [1], wherein the organic group X of the compound (C) is a substituted or unsubstituted $C_1$-$C_{20}$ alkyl group, a substituted or unsubstituted cyclohexyl group, or a substituted or unsubstituted $C_6$-$C_{20}$ aryl group, and a substituent group attached to the alkyl group, cyclohexyl group, or aryl group is a member selected from the group consisting of a $C_1$-$C_{12}$ alkyl group, a $C_6$-$C_{12}$ aryl group, hydroxyl group, methoxy group, and oxadiazole group.

[3] The resin composition for a reflective material according to [1] or [2], wherein the polyester resin (A1) contains: dicarboxylic acid component unit (a11) containing 30 to 100 mol% of a dicarboxylic acid component unit derived from terephthalic acid, and 0 to 70 mol% of an aromatic dicarboxylic acid component unit derived from an aromatic dicarboxylic acid exclusive of terephthalic acid; and dialcohol component unit (a12) containing a $C_4$-$C_{20}$ alicyclic dialcohol component unit and/or an aliphatic dialcohol component unit.

[4] The resin composition for a reflective material according to [3], wherein the alicyclic dialcohol component unit has a cyclohexane skeleton.

[5] The resin composition for a reflective material according to [3] or [4], wherein the dialcohol component unit (a12) contains 30 to 100 mol% of a cyclohexanedimethanol component unit, and 0 to 70 mol% of the aliphatic dialcohol component unit.

[6] The resin composition for a reflective material according to [1] or [2], wherein the polyamide resin (A2) contains: dicarboxylic acid component unit (a21) containing 40 to 100 mol% of a dicarboxylic acid component unit derived from terephthalic acid, and 0 to 60 mol% of an aromatic dicarboxylic acid component unit derived from an aromatic dicarboxylic acid exclusive of terephthalic acid; and diamine component unit (a22) containing 50 to 100 mol% of a $C_4$-$C_{18}$ aliphatic diamine component unit.

[7] The resin composition for a reflective material according to [6], wherein the aliphatic diamine component unit is at least one member selected from the group consisting of a 1,9-nonanediamine unit and a 2-methyl-1,8-octane diamine unit.

[8] The resin composition for a reflective material according to any one of [1] to [7], wherein the organic group X of the compound (C) is a member selected from the group consisting of methyl group, ethyl group, n-propyl group, n-octyl group, n-tetradecyl group, n-hexadecyl group, 2,4-di-t-butylphenyl group, and 2,4-di-t-pentylphenyl group.

[9] The resin composition for a reflective material according to any one of [1] to [8] further comprising 5 to 50 mass% of a reinforcing material (D) relative to 100 mass% of the total of components (A), (B) and (C).

[10] A reflector obtained by molding the resin composition for a reflective material according to any one of [1] to [9].

[11] The reflector according to [10] which is a reflector for a light-emitting diode element.

## Advantageous Effects of Invention

The resin composition of the present invention can provide a reflector which has high reflectance, and which at the same time, maintains high whiteness while suppressing discoloration to a low level and achieves small reduction of reflectance even when exposed to not only heat during production of an LED package or reflow soldering at the time of mounting of the LED package, but also heat and light generated from an LED element under the operating environment.

## Description of Embodiments

Polyester resins, such as PCT, and semi-aromatic polyamide resins, such as PA9T and PA10T, have a high melting point and satisfactory heat resistance; but on the other hand, higher melting temperature is needed for obtaining a resin composition (in a pellet form or the like) or a molded product. Accordingly, the residence time in a molding machine is likely to become longer, and the resin is likely to deteriorate. Further, regarding the thus obtained molded products, suppression of the decomposition reaction of the resin after long-time exposure to heat, light or the like tends to become unsatisfactory.

The present inventors have found that an addition of a predetermined amount of compound (C) to polyester resin (A1) or polyamide resin (A2) having a high melting point enables an obtainment of a molded product having low discoloration and high reflectance, and suffering only a small reduction of reflectance after molding (in particular, enables small reduction of reflectance after molding).

The reason for the above advantageous effects is not clear, but it can be presumed as follows. The compound (C) can satisfactorily scavenge radicals generated during the kneading for obtaining a resin composition (in a pellet form or the like) or a molded product, and suppress the decomposition reaction of the resin. It is considered that a molded product having low discoloration and high reflectance is enabled by the above mechanism. Further, the compound (C) can scavenge radicals which are generated from the resin when the molded product is exposed to heat and/or light for a long time, and also can satisfactorily absorb ultraviolet light. It is considered that the above results in suppression of the decomposition reaction of the resin by light and/or heat and reduction of reflectance of the molded product.

By virtue of its a phenyl ester structure, the compound (C), in particular, tends to be highly compatible with a resin, such as PCT or PA9T, having a phenyl ester structure derived from terephthalic acid. Upon high-temperature melt kneading of the compound (C) with the above-mentioned resin, the compound (C) is likely to uniformly disperse in the resin and, therefore, is less likely to volatilize even though it has a low molecular weight, and can suppresses the decomposition reaction of the resin even when used in only a small amount. These features may lead to uniform suppression of discoloration of the molded product and also suppression of the reduction of reflectance of the molded product. Since the compound (C) can be used in a small amount, a problem accompanying the use of the compound (C) in a large amount, namely discoloration of the molded product due to discoloration of the compound (C) itself, can be suppressed. Further, it becomes possible to suppress the reduction of reflectance due to such a discoloration. The present invention has been made on the basis of such findings.

### 1. Resin Composition for Reflective Material

The resin composition of the present invention for a reflective material contains thermoplastic resin (A) composed of at least one member selected from the group consisting of polyester resin (A1) and polyamide resin (A2), white pigment (B) and compound (C).

### 1-1. Thermoplastic Resin (A)

The thermoplastic resin (A) contained in the resin composition of the present invention for a reflective material is composed of at least one member selected from the group consisting of polyester resin (A1) and polyamide resin (A2).

#### 1-1-1. Polyester Resin (A1)

The polyester resin (A1) preferably contains at least dicarboxylic acid component unit (a11) containing a component unit derived from an aromatic dicarboxylic acid, and dialcohol component unit (a12) containing a component unit derived from a dialcohol having an alicyclic skeleton.

The dicarboxylic acid component unit (a11) constituting the polyester resin (A1) preferably contains 30 to 100 mol% of a terephthalic acid component unit, and 0 to 70 mol% of an aromatic dicarboxylic acid component unit derived from an aromatic dicarboxylic acid exclusive of terephthalic acid. The total amount of the dicarboxylic acid component units in the dicarboxylic acid component unit (a11) is 100 mol%.

The proportion of the terephthalic acid component unit in the dicarboxylic acid component unit (a11) is more

preferably 40 to 100 mol%, and can be still more preferably 60 to 100 mol%. The heat resistance of the polyester resin (A1) is likely to become improved when the proportion of the terephthalic acid component unit is at or above a predetermined value. The proportion of the aromatic dicarboxylic acid component unit, which is derived from an aromatic dicarboxylic acid exclusive of terephthalic acid, in the dicarboxylic acid component unit (a11) is more preferably 0 to 60 mol%, and can be still more preferably 0 to 40 mol%.

The terephthalic acid component unit may be a component unit derived from terephthalic acid or a terephthalic acid ester. The terephthalic acid ester is preferably a $C_1$-$C_4$ alkyl ester of terephthalic acid, and an example of such a terephthalic acid ester is dimethyl terephthalate.

Preferred examples of the aromatic dicarboxylic acid component units derived from an aromatic dicarboxylic acid exclusive of terephthalic acid include component units derived from isophthalic acid, 2-methyl terephthalic acid, naphthalene dicarboxylic acid and the combinations thereof, and component units derived from esters of these aromatic dicarboxylic acids (preferably $C_1$-$C_4$ alkyl esters of the aromatic dicarboxylic acids).

The dicarboxylic acid component unit (a11) may further contain a small amount of an aliphatic dicarboxylic acid component unit or a polycarboxylic acid component unit in addition to the above component units. The total proportion of the aliphatic dicarboxylic acid component unit and the polycarboxylic acid component unit in the dicarboxylic acid component unit (a11) can be, e.g., 10 mol% or less.

The number of carbon atoms of the aliphatic dicarboxylic acid component unit is not particularly limited, but is preferably 4 to 20, and more preferably 6 to 12. Examples of the aliphatic dicarboxylic acid units include component units derived from aliphatic dicarboxylic acids such as adipic acid, suberic acid, azelaic acid, sebacic acid, decane dicarboxylic acid, undecane dicarboxylic acid, and dodecane dicarboxylic acid, and the component unit derived from adipic acid may be preferred. Examples of the polycarboxylic acid component units include component units derived from tribasic acids and polybasic acids such as trimellitic acid and pyromellitic acid.

The dialcohol component unit (a12) constituting the polyester resin (A1) preferably contains an alicyclic dialcohol component unit. The alicyclic dialcohol component unit preferably contains a component unit derived from a dialcohol having a $C_4$-$C_{20}$ alicyclic hydrocarbon skeleton. Examples of the dialcohols having an alicyclic hydrocarbon skeleton include alicyclic dialcohols such as 1,3-cyclopentanediol, 1,3-cyclopentanedimethanol, 1,4-cyclohexanediol, 1,4-cyclohexanedimethanol, 1,4-cycloheptanediol, and 1,4-cycloheptanedimethanol. Among these compounds, in view of heat resistance, water absorption properties, availability, and the like, a component unit derived from a dialcohol having a cyclohexane skeleton is preferred, and a component unit derived from cyclohexanedimethanol is more preferred.

While the alicyclic dialcohol has isomers of cis/trans configuration or the like, the trans configuration is preferred in view of heat resistance. Accordingly, the cis/trans ratio is preferably 50/50 to 0/100, and more preferably 40/60 to 0/100.

For increasing the melt-flowability or the like of the resin, the dialcohol component unit (a12) may further contain an aliphatic dialcohol component unit in addition to the alicyclic dialcohol component unit. Examples of the aliphatic dialcohols include ethylene glycol, trimethylene glycol, propylene glycol, tetramethylene glycol, neopentyl glycol, hexamethylene glycol, and dodecamethylene glycol.

The dialcohol component unit (a12) constituting the polyester resin (A1) preferably contains 30 to 100 mol% of the alicyclic dialcohol component unit (preferably the dialcohol component unit having a cyclohexane skeleton), and 0 to 70 mol% of the aliphatic dialcohol component unit. The total amount of the dialcohol component units in the dialcohol component unit (a12) is 100 mol%.

The proportion of the alicyclic dialcohol component unit (the dialcohol component unit having a cyclohexane skeleton) in the dialcohol component unit (a12) is more preferably 50 to 100 mol%, and can be still more preferably 60 to 100 mol%. The proportion of the aliphatic dialcohol component unit in the dialcohol component unit (a12) is more preferably 0 to 50 mol%, and can be still more preferably 0 to 40 mol%.

The dialcohol component unit (a12) may further contain a small amount of an aromatic dialcohol component unit in addition to the above constituent units. Examples of the aromatic dialcohols include aromatic diols such as bisphenols, hydroquinones, and 2,2-bis(4-β-hydroxyethoxy phenyl)propane.

1-1-2. Polyamide Resin (A2)

The polyamide resin (A2) preferably contains at least dicarboxylic acid component unit (a21) containing a component unit derived from an aromatic dicarboxylic acid, and diamine component unit (a22) containing a component unit derived from an aliphatic diamine.

The dicarboxylic acid component unit (a21) constituting the polyamide resin (A2) preferably contains 40 to 100 mol% of a terephthalic acid component unit, and 0 to 60 mol% of an aromatic dicarboxylic acid component unit derived from an aromatic dicarboxylic acid exclusive of terephthalic acid. The total amount of the dicarboxylic acid component units in the dicarboxylic acid component unit (a21) is 100 mol%.

The proportion of the terephthalic acid component unit in the dicarboxylic acid component unit (a21) is more preferably 60 to 100 mol%, and can be still more preferably 75 to 100 mol%. The heat resistance of the polyester resin

(A2) is likely to become improved when the proportion of the terephthalic acid component unit is at or above a predetermined value. The proportion of the aromatic dicarboxylic acid component unit, derived from an aromatic dicarboxylic acid exclusive of terephthalic acid, in the dicarboxylic acid component unit (a21) is more preferably 0 to 40 mol%, and can be still more preferably 0 to 25 mol%.

The terephthalic acid component unit may be a component unit derived from terephthalic acid or a terephthalic acid ester (a $C_1$-$C_4$ alkyl ester of terephthalic acid), as described above.

Preferred examples of the aromatic dicarboxylic acid component units derived from an aromatic dicarboxylic acid exclusive of terephthalic acid include component units derived from isophthalic acid, 2-methyl terephthalic acid, naphthalene dicarboxylic acid and the combinations thereof, and component units derived from esters of these aromatic dicarboxylic acids (preferably $C_1$-$C_4$ alkyl esters of the aromatic dicarboxylic acids), as described above.

The dicarboxylic acid component unit (a21) may further contain a small amount of an aliphatic dicarboxylic acid component unit or a polycarboxylic acid component unit in addition to the above constituent units. The total proportion of the aliphatic dicarboxylic acid component unit and the polycarboxylic acid component unit in the dicarboxylic acid component unit (a21) can be, e.g., 10 mol% or less. Examples of the aliphatic dicarboxylic acid component units and the polycarboxylic acid component units are as described above.

The diamine component unit (a22) constituting the polyamide resin (A2) preferably contains an aliphatic diamine component unit. The aliphatic diamine component unit is preferably a component unit derived from a $C_4$-$C_{18}$ aliphatic diamine. Examples of the $C_4$-$C_{18}$ aliphatic diamines include the following:

linear aliphatic diamines such as 1,6-hexanediamine, 1,7-heptanediamine, 1,8-octanediamine, 1,9-nonanediamine, 1,10-decanediamine, 1,11-undecanediamine and 1,12-dodecanediamine; and
branched aliphatic diamines such as 2-methyl-1,5-pentanediamine, 3-methyl-1,5-pentanediamine, 2,2,4-trimethyl-1,6-hexanediamine, 2,4,4-trimethyl-1,6-hexanediamine, 2-methyl-1,8-octanediamine and 5-methyl-1,9-nonanediamine. Units derived from these compounds can be contained individually or in combination. Among these compounds, 1,9-nonanediamine and/or 2-methyl-1,8-octanediamine are preferred for obtaining a resin composition having still higher heat resistance.

With respect to the diamine component unit (a22), the proportion of the component unit derived from a $C_4$-$C_{18}$ aliphatic diamine is preferably 50 to 100 mol%, more preferably 60 to 100 mol%, and still more preferably 75 to 100 mol%. The total amount of the diamine component units in the diamine component unit (a22) is 100 mol%.

When the aliphatic diamine component unit contains both the 1,9-nonanediamine unit and the 2-methyl-1,8-octanediamine unit, the molar ratio of the 1,9-nonanediamine unit to the 2-methyl-1,8-octanediamine unit (1,9-nonanediamine unit / 2-methyl-1,8-octanediamine unit) is preferably in the range of 95/5 to 50/50, and more preferably in the range of 85/15 to 55/45.

In addition to the aliphatic diamine component unit, the diamine component unit (a22) may further contain a small amount of an alicyclic diamine component unit or aromatic diamine component unit. Examples of the alicyclic diamine component units include component units derived from cyclohexanediamine, methylcyclohexanediamine, and isophoronediamine. Examples of the aromatic diamine component units include component units derived from p-phenylenediamine, m-phenylenediamine, xylylenediamines, 4,4'-diaminodiphenylmethane, 4,4'-diaminodiphenylsulfone, 4,4'-diaminodiphenylether, and the like.

1-1-3. Physical Properties

The melting point (Tm) or a glass transition temperature (Tg) of the thermoplastic resin (A) is 250 °C or higher as measured by means of a differential scanning calorimeter (DSC). The lower limit of the melting point (Tm) or glass transition temperature (Tg) is preferably 270 °C, and more preferably 280 °C. On the other hand, a preferred upper limit of the melting point (Tm) or glass transition temperature (Tg) is, e.g., 350 °C, and more preferably 335 °C. When the melting point or glass transition temperature is 250°C or more, the discoloration or deformation of a reflector (molded product of the resin composition) during reflow soldering can be suppressed. While, in principle, there is no limitation to the upper limit temperature, the melting point or glass transition temperature of 350 °C or lower is preferred for suppressing the decomposition of the thermoplastic resin (A) during melt molding.

The melting point of the polyester resin (A1) can be measured by means of a differential scanning calorimeter (DSC) in accordance with JIS-K7121. Specifically, X-DSC7000 (manufactured by SII) is provided as a measuring apparatus. A sample of the polyester resin (A1) sealed in a pan for DSC measurement is set in the apparatus, and the temperature is elevated to 320 °C at a temperature-elevation rate of 10 °C/min in a nitrogen atmosphere, maintained thereat for 5 minutes, and then lowered to 30 °C at a temperature-lowering rate of 10 °C/min. The peak top temperature of an endothermic peak during the temperature elevation is used as a "melting point."

The melting point of the polyamide resin (A2) can be measured in substantially the same manner as described

above except that the temperature is elevated to 350 °C at a temperature-elevation rate of 10 °C/min in a nitrogen atmosphere.

The intrinsic viscosity [η] of the thermoplastic resin (A) is preferably 0.3 to 1.2 dl/g. When the intrinsic viscosity is in the above-mentioned range, the flowability during molding of the resin composition for a reflective material becomes excellent. The intrinsic viscosity of the thermoplastic resin (A) can be adjusted by, e.g., adjusting the molecular weight of the thermoplastic resin (A). For example, the molecular weight of the polyester resin (A1) can be adjusted by a conventional method, such as adjustment of the degree of progress of a polycondensation reaction, or addition of an adequate amount of a monofunctional carboxylic acid, a monofunctional alcohol, or the like.

The intrinsic viscosity of the polyester resin (A1) can be measured by the following process.

The polyester resin (A1) is dissolved in a mixed solvent of 50/50 mass% phenol and tetrachloroethane to obtain a sample solution. The falling time (seconds) of the obtained sample solution is measured using an Ubbelohde viscometer at 25 °C±0.05 °C, and the intrinsic viscosity [η] is calculated by applying the measurement to the following equations.

$$[\eta] = \eta SP/[C(1 + k\eta SP)]$$

[η]: intrinsic viscosity (dl/g)
ηSP: specific viscosity
C: sample concentration (g/dl)
t: falling time (seconds) of sample solution
t0: falling time (seconds) of a solvent
k: constant (slope determined by measuring the specific viscosity of (3 or more) samples having different solution concentrations, and plotting ηSP/C on the abscissa against the solution concentration of the ordinate)

$$\eta SP = (t-t0)/t0$$

Polyester resin (A1) can be obtained by, e.g., reacting dicarboxylic acid component unit (a11) and dialcohol component unit (a12) with a molecular weight modifier or the like blended into a reaction system. As described above, the intrinsic viscosity of the polyester resin (A1) can be adjusted by blending a molecular weight modifier into the reaction system.

The molecular weight modifier may be a monocarboxylic acid or a monoalcohol. Examples of the monocarboxylic acids include $C_2$-$C_{30}$ aliphatic monocarboxylic acids, aromatic monocarboxylic acids and alicyclic monocarboxylic acids. The aromatic monocarboxylic acid and the alicyclic monocarboxylic acid may have a substituent group in the cyclic structure thereof. Examples of the aliphatic monocarboxylic acids include acetic acid, propionic acid, butyric acid, valeric acid, caproic acid, caprylic acid, lauric acid, tridecyl acid, myristic acid, palmitic acid, stearic acid, oleic acid, and linoleic acid. Examples of the aromatic monocarboxylic acids include benzoic acid, toluic acid, naphthalene carboxylic acid, methylnaphthalene carboxylic acid, and phenylacetic acid, and an example of the alicyclic monocarboxylic acid is cyclohexane carboxylic acid.

The amount of the molecular weight modifier added may be 0 to 0.07 moles, and preferably 0 to 0.05 moles, relative to total 1 mole of the dicarboxylic acid component unit (a11) used in the reaction between the dicarboxylic acid component unit (a11) and the dialcohol component unit (a12).

The intrinsic viscosity [η] of the polyamide resin (A2) can be measured in substantially the same manner as described above except that concentrated sulfuric acid is used in place of the above-described mixed solvent, and the measurement is performed at 30 °C.

The content of the thermoplastic resin (A) in the resin composition of the present invention for a reflective material is preferably 45 to 80 mass%, more preferably 45 to 70 mass%, and still more preferably 50 to 60 mass%, relative to the total amount of the thermoplastic resin (A), white pigment (B), and compound (C). When the content of the thermoplastic resin (A) is at or above a predetermined value, more likely obtained is a resin composition for a reflective material having excellent heat resistance which enables the composition to withstand reflow soldering without impairing moldability. When the thermoplastic resin (A) contains both the polyester resin (A1) and polyamide resin (A2), the content of the thermoplastic resin (A) is the total of the contents of the polyester resin (A1) and polyamide resin (A2).

1-2. White Pigment (B)

The white pigment (B) in the resin composition of the present invention for a reflective material may be any substance as long as it can whiten the resin composition and improve the light-reflective function. Specifically, the

refractive index of the white pigment (B) is preferably 2.0 or more. The upper limit of the refractive index of the white pigment (B) can be, e.g., 4.0. Specific examples of the white pigments (B) include titanium oxide, zinc oxide, zinc sulfide, lead white, zinc sulfate, barium sulfate, calcium carbonate, and aluminium oxide. These white pigments (B) may be used individually or in combination. Among these, titanium oxide is preferred for obtaining a molded product having high reflectance, concealability, and the like.

The titanium oxide is preferably a rutile-type titanium oxide. The average particle diameter of the titanium oxide is preferably 0.1 to 0.5 μm, and more preferably 0.15 to 0.3 μm.

The white pigment (B) may be treated with a silane coupling agent, titanium coupling agent, or the like. For example, the white pigment (B) may be subjected to a surface treatment with a silane compound such as vinyltriethoxysilane, 2-aminopropyltriethoxysilane, or 2-glycidoxypropyltriethoxysilane.

From the view point of achieving uniform reflectance or the like, it is preferred that the white pigment (B) has a small aspect ratio, i.e., nearly spherical shape.

The content of the white pigment (B) in the resin composition for a reflective material is 17 to 54.99 mass%, preferably 20 to 50 mass%, and more preferably 20 to 40 mass%, relative to the total amount of the thermoplastic resin (A), the white pigment (B), and compound (C). When the content of the white pigment (B) is 17 mass% or more, it is more likely to obtain satisfactory whiteness, and to increase reflectance of the molded product. When the content of the white pigment (B) is 54.99 mass% or less, moldability is less likely to be impaired.

The content of the white pigment (B) relative to the thermoplastic resin (A) can be, e.g., 30 to 90 mass%, and preferably 60 to 80 mass%.

1-3. Compound (C)

The compound (C) contained in the resin composition of the present invention for a reflective material may be a compound having at least one structure represented by the following formula (A).

Formula (A)

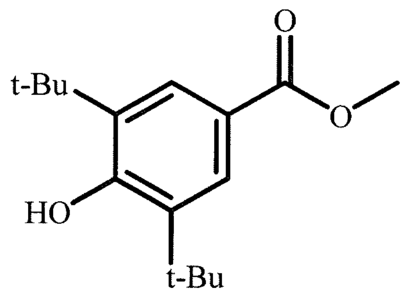

The number of the structures represented by formula (A) in one molecule may be, for example, 1 to 4, but is preferably 1. That is, the compound (C) is preferably a compound represented by the following general formula (1).

General formula (1)

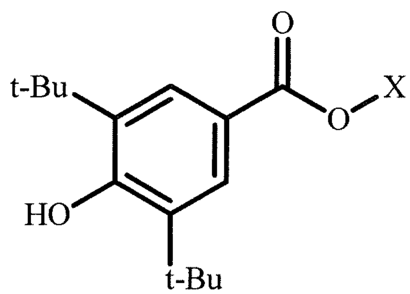

In general formula (1), X represents an organic group. The organic group X is a substituted or unsubstituted $C_1$-$C_{20}$ alkyl group, a substituted or unsubstituted cyclohexyl group, or a substituted or unsubstituted $C_6$-$C_{20}$ aryl group, and is preferably a substituted or unsubstituted $C_1$-$C_{20}$ alkyl group, or a substituted or unsubstituted $C_6$-$C_{20}$ aryl group.

Examples of the substituted or unsubstituted $C_1$-$C_{20}$ alkyl groups include methyl group, ethyl group, n-propyl

group, n-octyl group, n-tetradecyl group, and n-hexadecyl group. Examples of the substituted or unsubstituted $C_6$-$C_{20}$ aryl groups include 2,4-di-t-butylphenyl group and 2,4-di-t-pentylphenyl group.

The alkyl group, cyclohexyl group or aryl group represented by the organic group X may have a substituent group which is preferably a member selected from the group consisting of a $C_1$-$C_{12}$ alkyl group, such as methyl group or ethyl group; a $C_6$-$C_{12}$ aryl group, such as phenyl group; hydroxyl group; methoxy group; and oxadiazole group.

The molecular weight of the compound (C) is preferably 200 to 2,000, and more preferably 200 to 1,000. When the molecular weight of the compound (C) is in the above range, the amount of volatilized compound (C) is small during melting, and at the same time, the compound (C) is likely to mix well with other components, thereby maintaining the flowability of the resin composition.

The compound (C) can have a radical scavenging function. By virtue of such a function, the compound (C) scavenges radicals which are generated during the production or molding of the resin composition or by heat and/or light applied to the molded product under the operating environment, and can suppress heat decomposition of the thermoplastic resin (A) during the production or molding thereof, and the heat and light decomposition of the thermoplastic resin (A) in the molded product. The compound (C) can also have an ultraviolet ray (UV) absorbing function. By virtue of such a function, the compound (C) can suppress light decomposition of the thermoplastic (A) in the molded product. As a result, a molded product having low discoloration and high reflectance can be obtained, and reduction of reflectance of the molded product may become smaller.

Particularly, the compound (C) as shown in general formula (1) has a structure such that an oxycarbonyl group is directly bonded to a benzene ring. Such a structure imparts a satisfactory radical scavenging property to the compound (C).

The content of the compound (C) in the resin composition for a reflective material is 0.01 to 3 mass%, preferably 0.05 to 1.5 mass%, and more preferably 0.1 to 1.1 mass%, relative to the total amount of the thermoplastic resin (A), the white pigment (B), and the compound (C). When the content of the compound (C) is 0.01 mass% or more, it becomes more easy to achieve satisfactory whiteness by suppressing heat and light deterioration of the resin in a molded product, and to achieve a smaller reduction of reflectance. When the content of the compound (C) is 3 mass% or less, it becomes possible to minimize the reduction of reflectance of the molded product caused by discoloration and/or hue deterioration resulting from the decomposition products of the compound (C).

The content of the compound (C), relative to the thermoplastic resin (A), can be 0.25 to 2.0 mass%, preferably 0.27 to 1.0 mass%. When the content of the compound (C) is at or above a predetermined value, the decomposition reaction of the thermoplastic resin (A) in the molded product after long-time exposure to heat and/or light can be satisfactorily suppressed. When the content of the compound (C) is at or below a predetermined value, it becomes possible to minimize the reduction of reflectance of the molded product caused by discoloration and/or hue deterioration resulting from the decomposition products of the compound (C).

1-4. Reinforcing Material (D)

The resin composition of the present invention for a reflective material may further contain a reinforcing material (D) as necessary. The shape of the reinforcing material (D) is spherical, fibrous, tabular or the like, and for easily imparting satisfactory strength and toughness to a molded product, a fibrous reinforcing material (D) is preferred.

Examples of the above fibrous reinforcing materials include glass fiber, wollastonite, potassium titanate whisker, calcium carbonate whisker, aluminum borate whisker, magnesium sulfate whisker, sepiolite, xonotlite, zinc oxide whisker, milled fiber, and cut fiber. These may be used individually or in combination. Among these, preferred is at least one member selected from the group consisting of wollastonite, glass fiber and potassium titanate whisker, and this is due to their relatively small average fiber diameter, capability of increasing surface smoothness of a molded product, and the like, and more preferred are wollastonite and glass fiber. Wollastonite is preferred for its high light shielding effect, and glass fiber is preferred for its high mechanical strength.

The average fiber length (1) of the fibrous reinforcing material in the resin composition for a reflective material is generally 5 mm or less, preferably 300 μm or less, more preferably 100 μm or less, and still more preferably 50 μm or less. When the average fiber length (1) is at or below a predetermined value, the fibrous reinforcing material tends to not only withstand breakage during molding, but also finely disperse in the resin. Accordingly, excess stress applied to the resin during the molding or the like becomes reduced, and the heat decomposition of the resin is likely to become suppressed. Further, the fibrous reinforcing material is more likely to increase the surface smoothness of the obtained molded product. There is no limitation to the lower limit of the average fiber length (1), but 2 μm is preferred, and 8 μm can be more preferred. The average fiber length (1) of 2 μm or more can impart satisfactory strength to the molded product.

For easily and finely dispersing the fibrous reinforcing material during the molding or the like, and increasing surface smoothness of the molded product, the average fiber diameter (d) of the fibrous reinforcing material in the resin composition for a reflective material is preferably at or below a predetermined value, and in particular, 0.05 to 30 μm is preferred and 2 to 6 μm is more preferred. Adjustment of an average fiber diameter (d) to a predetermined value or

more may suppress breakage or the like of the fibrous reinforcing material (B) during the production or molding of the resin composition. The fibrous reinforcing material (B) having an average fiber diameter (d) at or above a predetermined value is likely to impart high surface smoothness to a molded product, thereby achieving high reflectance.

The average fiber length (1) and average fiber diameter (d) of the fibrous reinforcing material in the resin composition for a reflective material (e.g., in the form of a compound such as pellets) can be measured by the following method.

1) The resin composition for a reflective material is dissolved in hexafluoroisopropanol/chloroform solution (0.1/0.9 vol%), followed by filtration of the resultant solution to thereby obtain filtration residues.
2) 100 arbitrary fibers of the fibrous reinforcing material obtained from the obtained residues are observed under a scanning electron microscope (SEM) at a magnification of 50, and the fiber length and fiber diameter of each fiber are measured. The average of the fiber lengths can be used as the average fiber length (1), and the average of the fiber diameters can be used as the average fiber diameter (d).

The aspect ratio (1/d) of the fibrous reinforcing material which is obtained by dividing the average fiber length (1) by the average fiber diameter (d) is preferably 2 to 20, and more preferably 7 to 12. When the aspect ratio is at or above a predetermined value, it becomes easy to impart at least a certain level of strength or rigidity to the molded product.

The content of the reinforcing material (D) in the resin composition for a reflective material can be 5 to 50 mass% and preferably 5 to 40 mass%, relative to the total amount of the thermoplastic resin (A), the white pigment (B), and the compound (C). When the content of the reinforcing material (D) is 5 mass% or more, it is more likely to improve the heat resistance of the resin composition, and impart high surface smoothness to the molded product. When the content of the reinforcing material (D) is 50 mass% or less, it is less likely to impair the moldability of the resin composition.

1-5. Other Components (E)

The resin composition of the present invention for a reflective material may contain an arbitrary component in accordance with applications as long as the effect of the present invention is not impaired. Examples of the arbitrary components include antioxidants (such as amine-based, sulfur-based, and phosphorus-based antioxidants), light stabilizers (such as benzotriazoles, triazines, benzophenones, hindered amines, and oxanilides), heat-resistant stabilizers (such as lactone compounds, vitamin E, hydroquinones, copper halides, and iodine compounds), other polymers (such as polyolefins, ethylene-propylene copolymers, olefin copolymers such as ethylene-1-butene copolymers, olefin copolymers such as propylene-1-butene copolymers, polystyrenes, polyamides, polycarbonates, polyacetals, polysulfones, polyphenylene oxides, fluororesins, silicone resins, and LCP), flame retardants (such as bromine-based, chlorine-based, phosphorus-based, antimony-based, and inorganic flame retardants), fluorescent brightening agents, plasticizers, thickeners, antistatic agents, release agents, pigments, crystal nucleating agents, and various conventional compounding agents.

When the resin composition of the present invention for a reflective material is used in combination with other components, the selection of the above-mentioned additive may become important in some cases. For example, when other components combined include a catalyst or the like, it is preferred to avoid the use of an additive containing a component or element which may act as a catalyst poison. Examples of such additives which are preferably avoided include compounds containing sulfur.

1-6. Physical Properties

The resin composition for a reflective material of the present invention can have satisfactory moldability. Specifically, the flow length of the resin composition for a reflective material during injection molding under the below-mentioned conditions is preferably 30 mm or more, more preferably 31 mm or more.

Injection molding apparatus: Tuparl TR40S3A, Sodick Co., Ltd.
Injection set pressure: 2,000 kg/cm$^2$
Cylinder set temperature: melting point (Tm) + 10 °C
Mold temperature: 30 °C

For increasing the flowability of the resin composition of the present invention for a reflective material, it is preferred that, for example, the content of the white pigment (B) or the reinforcing material (D) is adjusted to a predetermined content or less.

2. Method of Producing Resin Composition for Reflective Material

The resin composition of the present invention for a reflective material can be produced by a conventional method, such as a method in which the above components are mixed together by means of a Henschel mixer, a V-blender, a ribbon blender, a tumbler blender or the like to thereby obtain a mixture, or a method in which the thus obtained mixture is further melt kneaded by means of a single-screw extruder, a multi-screw extruder, a kneader, a Banbury mixer, or the like, followed by granulation or pulverization.

The resin composition of the present invention for a reflective material may be preferably in the form of a compound such as a pellet which is obtained by mixing the above components by means of a single-screw extruder, a multi-screw extruder or the like, melt kneading the resultant mixture, and granulating or pulverizing the melt-kneaded mixture. The compound is suitably used as a molding material. The melt kneading is preferably performed at a temperature which is 5 to 30 °C higher than the melting point of the polyester resin (A1) or polyamide resin (A2). The lower limit of the melt-kneading temperature is preferably 255 °C, more preferably 275 °C and still more preferably 295 °C, and the upper limit is preferably 360 °C, and more preferably 340 °C.

3. Reflector

The reflector of the present invention may be a molded product obtained by molding the resin composition of the present invention for a reflective material.

For the molded product to function satisfactorily as a reflector, it is preferred that the molded product of the resin composition of the present invention for a reflective material has light reflectance at a wavelength of 450 nm of 90% or more, more preferably 94% or more. Reflectance can be measured using CM3500d manufactured by KONICA MINOLTA, INC. The thickness of the molded product at the time of measurement may be 0.5 mm.

It is preferred that the molded product of the resin composition of the present invention for a reflective material suffers only a small reduction of reflectance even when heat and/or light is applied thereto. Specifically, the light reflectance of the molded product at a wavelength of 450 nm, as measured after heating at 150 °C for 500 hours, can be, e.g., 90% or more when the polyester resin (A1) is used, and e.g., 70% or more when the polyamide resin (A2) is used. The light reflectance of the molded product at a wavelength of 450 nm as measured after UV irradiation at 16 $mW/cm^2$ for 500 hours can be, e.g., 82% or more when the polyester resin (A1) is used, and e.g., 70% or more when the polyamide resin (A2) is used. The thickness of the molded product used for the measurement may be 0.5 mm. For maintaining the reflectance, the above compound (C) is preferably contained in a predetermined amount or more.

The reflector of the present invention may be a casing or housing having at least a light-reflecting surface. The light-reflecting surface may be a planar surface, a curved surface, or a spherical surface. For example, the reflector may be a molded product having a light reflecting surface in the shape of a box, a case, a funnel, a bowl, a parabola, a cylinder, a circular cone, a honeycomb or the like.

The reflector of the present invention is used as a reflector for a various light sources such as an organic EL and a light-emitting diode element (LED). Among these, the use as a reflector for a light-emitting diode element (LED) is preferred, and as a reflector for a light-emitting diode element (LED) applicable for surface mounting is more preferred.

The reflector of the present invention can be obtained by shaping the resin composition of the present invention for a reflective material into a desired shape by heat molding, such as injection molding, metal insert molding (particularly hoop molding or the like), melt molding, extrusion molding, inflation molding, or blow molding.

The reflector of the present invention can be obtained by molding the resin composition for a reflective material containing the compound (C). The compound (C) can satisfactorily scavenge radicals generated at a high temperature during production or molding of the resin composition and, is likely to suppress the heat decomposition reaction of the thermoplastic resin (A). Accordingly, a molded product having low discoloration and high reflectance can be obtained.

An LED package provided with the reflector of the present invention may have, for example, a housing which is molded on a substrate and which has a space for mounting an LED, an LED mounted inside the space, and a transparent sealing member sealing the LED. Such an LED package may be produced by the following steps: 1) molding a reflector on a substrate to thereby obtain a housing; 2) disposing an LED inside the housing and electrically connecting the LED with the substrate; and 3) sealing the LED with a sealant. During sealing, the LED package is heated at 100 to 200 °C for thermally curing the sealant. Further, during reflow soldering for mounting the LED package on a printed substrate, the LED package is exposed to a high temperature which is 250°C or higher.

The reflector obtained from the resin composition of the present invention for a reflective material contains compound (C), and even when the reflector is subjected to high-temperature heat treatment in the above-mentioned steps, or exposed to light (such as visible light and ultraviolet light) and heat generated from the LED for a long time under the operating environment, the compound (C) can satisfactorily scavenge radicals. Since the compound (C) can also absorb ultraviolet light or the like, it can reduce the amount of ultraviolet light applied to the resin. Accordingly, the light and/or heat decomposition reaction of the thermoplastic resin (A) in the molded product can be suppressed and,

thus, low discoloration and high reflectance can be maintained.

The reflector of the present invention can be used for various applications, for example, for various electric electronic components, interior illumination, exterior illumination, and automobile illumination.

## Examples

Hereinafter, the present invention is described with reference to Examples, which however shall not be construed as limiting the technical scope of the present invention.

### 1. Preparation of Materials

<Polyester Resin (A1)>

106.2 parts by mass of dimethyl terephthalate and 94.6 parts by mass of 1,4-cyclohexanedimethanol (cis/trans ratio: 30/70) (manufactured by Tokyo Chemical Industry Co., Ltd.) were mixed together. To the resultant mixture was added, 0.0037 parts by mass of tetrabutyl titanate, and the temperature was elevated from 150 °C to 300 °C over 3.5 hours to effect an ester exchange reaction.

At the completion of the above ester exchange reaction, 0.066 parts by mass of magnesium acetate tetrahydrate dissolved in 1,4-cyclohexanedimethanol was added to the reaction mixture, followed by an introduction of 0.1027 parts by mass of tetrabutyl titanate, thereby effecting a polycondensation reaction. During the polycondensation reaction, pressure was gradually reduced from normal pressure to 1 Torr over 85 minutes, and at the same time, the temperature was elevated to a predetermined polymerization temperature of 300 °C. Agitation of the mixture was continued while maintaining the temperature and pressure, and the reaction was terminated when agitation torque reached a predetermined value. The thus obtained polymer was taken out, and subjected to a solid phase polymerization at 260°C and 1 Torr or less for 3 hours, thereby obtaining polyester resin (A1).

The obtained polyester resin (A1) had an intrinsic viscosity [η] of 0.6 dl/g and a melting point of 290 °C. The intrinsic viscosity [η] and melting point were measured by the below-mentioned methods.

(Intrinsic Viscosity)

The obtained polyester resin (A1) was dissolved in a mixed solvent of 50/50 mass% phenol and tetrachloroethane to obtain a sample solution. The falling time (seconds) of the obtained sample solution was measured using an Ubbelohde viscometer at 25 °C ± 0.05 °C, and the intrinsic viscosity [η] was calculated by applying the results to the following equations.

$$[\eta] = \eta SP/[C(1 + k\eta SP)]$$

[η]: intrinsic viscosity (dl/g)
ηSP: specific viscosity
C: sample concentration (g/dl)
t: falling time (seconds) of sample solution
t0: falling time (seconds) of a solvent
k: constant (slope determined by measuring the specific viscosity of (3 or more) samples having different solution concentrations, and plotting ηSP/C on the abscissa against the solution concentration of the ordinate)

$$\eta SP = (t - t0)/t0$$

(Melting Point)

The melting point of the polyester (A1) was measured in accordance with JIS-K7121. X-DSC7000 (manufactured by SII) was used as a measuring apparatus. A sample of the polyester resin (A1) sealed in a pan for DSC measurement was set in the apparatus, and the temperature was elevated to 320 °C at a temperature-elevation rate of 10 °C/min in a nitrogen atmosphere, maintained thereat for 5 minutes, and then lowered to 30 °C at a temperature-lowering rate of 10 °C/min. The peak top temperature of an endothermic peak during the temperature elevation is used as a "melting point".

<Polyamide Resin (A2)>

An autoclave was charged with 23.9 parts by mass of terephthalic acid, 20.4 parts by mass of 1,9-nonanediamine, 3.6 parts by mass of 2-methyl-1,8-octanediamine, 0.3 parts by mass of benzoic acid, 0.3 parts by mass of sodium hypophosphite monohydrate, and distilled water, followed by a nitrogen purge. The resultant mixture was heated, agitation started at 190 °C, and continued over 3 hours until the internal temperature reached 250 °C, to thereby effect a reaction. During the heating, the internal pressure of the autoclave was increased to 3.03 MPa. The reaction was further continued for 1 hour, followed by air release from a spray nozzle provided at the bottom of the autoclave, thereby recovering a low-condensation product from the autoclave. The recovered low-condensation product was cooled to room temperature, pulverized to a particle size of 1.5 mm or less using a pulverizer, and dried at 110 °C for 24 hours. The resultant low-condensation product had a moisture content of 4,100 ppm and an intrinsic viscosity [η] of 0.13 dl/g.

Subsequently, the low-condensation product was charged into a shelf-type solid-phase polymerization apparatus, and after a nitrogen purge, the temperature of the apparatus was elevated to 180 °C over about 1.5 hours. The low-condensation product was subjected to a reaction for subsequent 1.5 hours, and the temperature was lowered to room temperature, thereby obtaining a polyamide. The obtained polyamide had an intrinsic viscosity [η] of 0.17 dl/g. Next, the obtained polyamide was charged into a biaxial extruder with a screw diameter of 30 mm and an L/D of 36, and subjected to melt polymerization under conditions such that a barrel preset temperature is 330 °C, a screw rotation speed is 200 rpm, and a resin feed rate is 5 Kg/h, thereby obtaining polyamide resin (A2).

The obtained polyamide resin (A2) had an intrinsic viscosity [η] of 0.91 dl/g and a melting point of 306 °C. The intrinsic viscosity [η] of the polyamide resin (A2) was measured in substantially the same manner as described above except that the measurement was performed in a concentrated sulfuric acid at 30 °C. The melting point of the polyamide resin (A2) was measured in substantially the same manner as described above except that the temperature was elevated to 350 °C at a temperature-elevation rate of 10 °C/min in a nitrogen atmosphere.

<White Pigment (B)>

Titanium oxide (in a powder form, average particle diameter*b: 0.21 μm)
*b: The average particle diameter of titanium oxide was determined from a transmission electron micrograph by an image analysis using an image analyzer (LUZEX IIIU).

<Compound (C)>

C-1: KEMISORB114 (Chemipro Kasei Kaisha, Ltd): A compound represented by the following formula:

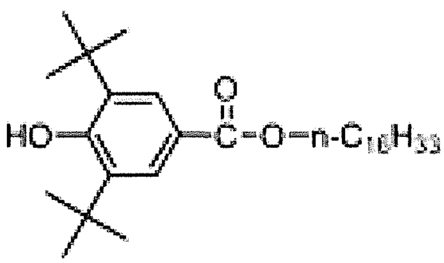

Molecular Weight 474.8.

C-2: KEMISORB113 (Chemipro Kasei Kaisha, Ltd): A compound represented by the following formula:

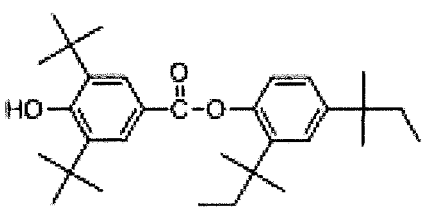

Molecular Weight 466.8.

<Comparative Compound>

R-1: Irganox1010 (BASF): Pentaerythritol tetrakis[3-(3,5-di-tert-butyl-4-hydroxyphenyl)propionate]

<Reinforcing Material (D)>

D-1: Wollastonite having an average fiber length (1): 50 μm, an average fiber diameter (d): 4.5 μm, and an aspect ratio (1/d): 11 (NYGLOS 4W, manufactured by TOMOE Engineering Co., Ltd.)
D-2: Glass Fiber having an average fiber length (1): 3 mm, and an irregular shape ratio: 4 [7 μm × 28 μm] (CSG 3PA-830 (Silane compound-treated product), manufactured by Nitto Boseki Co., Ltd.)

The average fiber length (1) and average fiber diameter (d) of wollastonite (D-1) and glass fiber (D-2) as raw materials were measured by the following method. With respect to 100 fibers of wollastonite or glass fiber, the fiber length and fiber diameter of each fiber were measured using a scanning electron microscope (SEM) at a magnification of 50. The average of the fiber lengths was used as the average fiber length (1), and the average of the fiber diameters was used as the average fiber diameter (d). The aspect ratio was determined by dividing the average fiber length by the average fiber diameter (l/d).

2. Production of Resin Composition for Reflective Material

[Example 1]

Using a tumbler blender were mixed, 54.85 parts by mass of the above synthesized polyester resin as polyester resin (A1), 35 parts by mass of the above titanium oxide as white pigment (B), 0.15 parts by mass of the compound (C-1) as compound (C), and 10 parts by mass of the above wollastonite (D-1) as a reinforcing materials (D). The resultant mixture was melt kneaded by means of a twin-screw extruder (TEX30α, manufactured by Japan Steel Works, Ltd.) at a cylinder temperature of 300 °C, and the kneaded mixture was then extruded into a strand. The extruded strand was cooled in a water tank, pulled out and cut using a pelletizer, thereby obtaining a pellet-shaped resin composition for a reflective material. The compoundability of the composition was confirmed to be satisfactory.

The average fiber length and average fiber diameter of the reinforcing material (D) in the obtained pellet-shaped resin composition for a reflective material were measured by the following method.

1) The obtained resin composition for a reflective material was dissolved in hexafluoroisopropanol/chloroform solution (0.1/0.9 vol%), and the resultant solution was filtered to obtain filtration residue.
2) 100 arbitrary fibers of the reinforcing material (D) obtained from the residue were observed under a scanning electron microscope (S-4800 manufactured by Hitachi, Ltd.) at a magnification of 50, and the fiber length and fiber diameter of each fiber were measured. The average of the measured fiber lengths was used as "the average fiber length," and the average of the measured fiber diameters was used as "the average fiber diameter."

As a result, with respect to fibers contained in the resin composition for a reflective material obtained in Example 1, the average fiber length was 23 μm, and the average fiber diameter was 2.9 μm.

[Examples 2, 3 and 5 to 9, and Comparative Examples 1 to 3]

Pellet-shaped resin compositions were obtained in substantially the same manner as in Example 1 except that the formulation of each resin composition was changed as shown in Table 1 or 2.

[Example 4 and Comparative Example 4]

Pellet-shaped resin compositions were obtained in substantially the same manner as in Example 1 except that the cylinder temperature was changed to 320 °C and the formulation of each resin composition was changed as shown in Table 1 or 2.

For each of the resin compositions obtained in Examples and Comparative Examples, various types of reflectance and flowability were evaluated by the following methods.

<Reflectance>

(Initial Reflectance)

Each of the obtained pellet-shaped resin compositions was injection molded using the below-mentioned molding machine under the below-mentioned conditions, thereby preparing a test specimen having a length of 30 mm, a width of 30 mm, and a thickness of 0.5 mm. The reflectance of the prepared test specimen within a wavelength range of 360 nm to 740 nm was determined using CM3500d manufactured by KONICA MINOLTA, INC. The reflectance at 450 nm was used as a representative value for the initial reflectance.

Molding machine: SE50DU manufactured by Sumitomo Heavy Industries, Ltd.
Cylinder temperature: Melting point (Tm) + 10°C
Mold temperature: 150°C

(Reflectance after Reflow test)

The test specimen used for measuring the initial reflectance was placed in a 170 °C oven for 2 hours. Subsequently, using an air reflow soldering apparatus (AIS-20-82-C, manufactured by Eightech Tectron Co., Ltd.), the test specimen was subjected to a heat treatment with a temperature profile in which the surface temperature of the test specimen was elevated to 260 °C and maintained thereat for 20 seconds (similar to the heat treatment for reflow soldering). After slowly cooling the resultant test specimen, the reflectance was measured in the same manner as the initial reflectance, and the measured value was used as the reflectance after the reflow test.

(Reflectance after Heating)

The test specimen used for measuring the initial reflectance was placed in a 150 °C oven for 500 hours. Subsequently, the reflectance of the resultant test specimen was measured in the same manner as the initial reflectance, and the measured value was used as the reflectance after heating.

(Reflectance after Ultraviolet Ray (UV) Irradiation)

The test specimen used for measuring the initial reflectance was placed in the below-mentioned UV irradiator for 500 hours. Subsequently, the reflectance of the resultant test specimen was measured in the same manner as the initial reflectance, and the measured value was used as the reflectance after UV irradiation.

UV irradiator: SUPER WIN MINI, manufactured by DAYPLA WINTES CO., LTD.
Output: 16 $mW/cm^2$

<Flowability>

Each of the obtained resin compositions was injection molded under the below-mentioned conditions using a bar-flow mold having a width of 10 mm and a thickness of 0.5 mm to thereby measure the flow length (mm) of the resin in the mold.

Injection molding machine: Tuparl TR40S3A, Sodick Co., Ltd.
Injection set pressure: 2,000 kg/cm2
Cylinder set temperature: melting point (Tm) + 10°C
Mold temperature: 30°C

The evaluation results of Examples 1 to 9 are shown in Table 1, and the evaluation results of Comparative Examples 1 to 4 are shown in Table 2.

[Table 1]

| | | | Unit | Ex. 1 | Ex. 2 | Ex. 3 | Ex. 4 | Ex. 5 | Ex. 6 | Ex. 7 | Ex. 8 | Ex. 9 |
|---|---|---|---|---|---|---|---|---|---|---|---|---|
| Composition | Thermoplastic Resin (A) | Polyester (A1) | parts by mass | 54.85 | 54.7 | 54 | 0 | 59.5 | 59.5 | 64.85 | 49.85 | 59.85 |
| | | Polyamide (A2) | parts by mass | 0 | 0 | 0 | 59.7 | 0 | 0 | 0 | 0 | 0 |
| | White Pigment (B) | Titanium Oxide | parts by mass | 35 | 35 | 35 | 20 | 20 | 20 | 35 | 20 | 20 |
| | Compound (C) | C-1 | parts by mass | 0.15 | 0.3 | 1 | 0.5 | 0.5 | 0 | 0.15 | 0.15 | 0.15 |
| | | C-2 | parts by mass | 0 | 0 | 0 | 0 | 0 | 0.5 | 0 | 0 | 0 |
| | | R-1 | parts by mass | 0 | 0 | 0 | 0 | 0 | 0 | 0 | 0 | 0 |
| | Reinforcing Material (D) | D-1 | parts by mass | 10 | 10 | 10 | 0 | 0 | 0 | 0 | 30 | 0 |
| | | D-2 | parts by mass | 0 | 0 | 0 | 20 | 20 | 20 | 0 | 0 | 20 |
| Evaluation | Reflectance | Initial [450nm] | % | 95.1 | 95.1 | 94.7 | 93.8 | 94.7 | 94.6 | 96.3 | 93.7 | 94.6 |
| | | After Reflow Test [450nm] | % | 93.1 | 93.1 | 93 | 90.1 | 93.2 | 92.7 | 94.8 | 89.7 | 93.0 |
| | | After Heating 150°C×500h [450nm] | % | 91.2 | 91.3 | 91.3 | 71.2 | 91.3 | 91 | 91.7 | 87.1 | 91.0 |
| | | After UV Irradiation 16mW/cm$^2$×500h [450nm] | % | 88.6 | 89.2 | 88.7 | 75.4 | 82.9 | 82.7 | 87.6 | 84.1 | 82.6 |
| | Flowability | 0.5L/t (Flow length) | mm | 31 | 32 | 31 | 22 | 38 | 38 | 38 | 26 | 38 |

[Table 2]

| | | | Unit | Comp. Ex. 1 | Comp. Ex. 2 | Comp. Ex. 3 | Comp. Ex. 4 |
|---|---|---|---|---|---|---|---|
| Composition | Thermoplastic Resin (A) | Polyester (A1) | parts by mass | 55 | 50 | 59.5 | 0 |
| | | Polyamide (A2) | parts by mass | 0 | 0 | 0 | 59.7 |
| | White Pigment (B) | Titanium Oxide | parts by mass | 35 | 35 | 20 | 20 |
| | Compound (C) | C-1 | parts by mass | 0 | 5 | 0 | 0 |
| | | C-2 | parts by mass | 0 | 0 | 0 | 0 |
| | | R-1 | parts by mass | 0 | 0 | 0.5 | 0.5 |
| | Reinforcing Material (D) | D-1 | parts by mass | 10 | 10 | 0 | 0 |
| | | D-2 | parts by mass | 0 | 0 | 20 | 20 |
| Evaluation | Reflectance | Initial [450nm] | % | 94.3 | 93.5 | 94.2 | 93 |
| | | After Reflow Test [450nm] | % | 90.2 | 91 | 92.6 | 86.2 |
| | | After Heating 150 °C×500h [450nm] | % | 79.4 | 87.2 | 86.4 | 60.3 |
| | | After UV Irradiation 16mW/cm$^2$×500h [450nm] | % | 86 | 86.7 | 81.1 | 66.2 |
| | Flowability | 0.5L/t (Flow length) | mm | 32 | 28 | 38 | 22 |

As shown in Tables 1 and 2, the resin compositions of Examples 1 to 9 each containing the compound (C) have high reflectance and suffer only a small reduction of reflectance after heating or light irradiation, as compared to the resin compositions of Comparative Examples 1, 3 and 4 which do not contain the compound (C). It is considered that the high reflectance and small reduction in reflectance is achieved by the compound (C) capable of scavenging radicals generated by, e.g., application of heat during production of or molding into the pellet-shaped resin compositions, or application of heat and/or light after the molding, and suppressing the decomposition reaction of the polyester resin (A1) or polyamide resin (A2).

Comparison between Examples 1 to 3 and Comparative Example 2 shows that the resin compositions of Examples 1 to 3 which contain the compound (C) in a predetermined content or less show high reflectance for initial measurement and measurements after the reflow test, after heating and after UV irradiation, as compared to the resin composition of Comparative Example 2 which contains too large content of the compound (C). That is, the compound (C) having high compatibility with molten polyester resin (A1), volatilizes in only a small amount despite its low molecular weight and disperses uniformly even when used in a small amount, thereby suppressing discoloration of the polyester resin (A1). The mechanism for the suppression of discoloration is not clearly understood, but it is considered that the suppression of discoloration is the result of suppression of resin deterioration by the compound (C) which not only

scavenges radicals generated during high-temperature kneading, but also caps the molecular terminals of the polyester resin (A1) by ester exchange reaction between the compound (C) and the polyester resin (A1).

Comparison between Example 4 and Example 5 shows that the resin composition of Example 5 containing the polyester resin (A1) has higher reflectance after heating, as compared to the resin composition of Example 4 containing the polyamide resin (A2). Possible cause of such a difference in reflectance is unsatisfactory suppression of discoloration caused by amide groups of the polyamide resin (A2) in the resin composition of Example 4.

Comparison among Examples 1, 7 and 8 shows that the resin composition of Example 1 containing an adequate amount of the reinforcing material (D) shows a smaller reduction of reflectance, as compared to the resin composition of Example 7 not containing any reinforcing material (D) and the resin composition of Example 8 containing a relatively large amount of the reinforcing material (D).

Comparison between Example 9 and Comparative Example 3 shows that the resin composition of Example 9 not only has high initial reflectance, but also shows satisfactorily suppressed reduction of reflectance after heating. It is apparent from the above that the compound (C) is capable of strongly suppressing discoloration of the polyester resin (A1) even when used in only a small amount.

This application claims priority based on Japanese Patent Application No. 2014-134749, filed on June 30, 2014, the entire contents of which including the specification are incorporated herein by reference.

Industrial Applicability

The resin composition of the present invention for a reflective material enables production of a reflector which suffers only a small reduction of reflectance even under heat during, e.g., the production of an LED package or reflow soldering for mounting the LED package, or upon exposure to heat and light from a light source under the operating environment.

## Claims

1. A resin composition for a reflective material, comprising:

   45 to 80 mass% of thermoplastic resin (A) having a melting point (Tm) or a glass transition temperature (Tg) of 250 °C or higher as measured by means of a differential scanning calorimeter (DSC) in accordance with JIS-K7121 according to the description, the thermoplastic resin (A) being composed of at least one member selected from the group consisting of polyester resin (A1) and polyamide resin (A2);
   17 to 54.99 mass% of white pigment (B); and
   0.01 to 3 mass% of compound (C), the compound (C) being at least one type of a compound represented by general formula (1):

   General formula (1)

   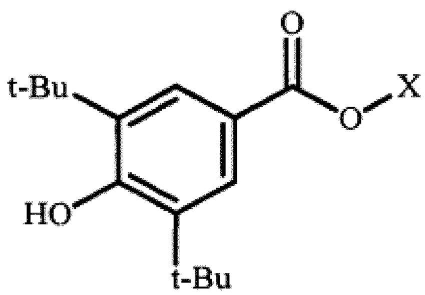

   wherein X represents an organic group,
   total of components (A), (B) and (C) being 100 mass%.

2. The resin composition for a reflective material according to claim 1, wherein the organic group X of the compound (C) is a substituted or unsubstituted $C_1$-$C_{20}$ alkyl group, a substituted or unsubstituted cyclohexyl group, or a substituted or unsubstituted $C_6$-$C_{20}$ aryl group, and
   a substituent group attached to the alkyl group, cyclohexyl group, or aryl group is a member selected from the group consisting of a $C_1$-$C_{12}$ alkyl group, a $C_6$-$C_{12}$ aryl group, hydroxyl group, methoxy group, and oxadiazole group.

**3.** The resin composition for a reflective material according to claim 1 or 2, wherein the polyester resin (A1) contains:

dicarboxylic acid component unit (a11) containing 30 to 100 mol% of a dicarboxylic acid component unit derived from terephthalic acid, and 0 to 70 mol% of an aromatic dicarboxylic acid component unit derived from an aromatic dicarboxylic acid exclusive of terephthalic acid; and
dialcohol component unit (a12) containing a $C_4$-$C_{20}$ alicyclic dialcohol component unit and/or an aliphatic dialcohol component unit.

**4.** The resin composition for a reflective material according to claim 3, wherein the alicyclic dialcohol component unit has a cyclohexane skeleton.

**5.** The resin composition for a reflective material according to claim 3 or 4, wherein the dialcohol component unit (a12) contains 30 to 100 mol% of a cyclohexanedimethanol component unit, and 0 to 70 mol% of the aliphatic dialcohol component unit.

**6.** The resin composition for a reflective material according to claim 1 or 2, wherein the polyamide resin (A2) contains:

dicarboxylic acid component unit (a21) containing 40 to 100 mol% of a dicarboxylic acid component unit derived from terephthalic acid, and 0 to 60 mol% of an aromatic dicarboxylic acid component unit derived from an aromatic dicarboxylic acid exclusive of terephthalic acid; and
diamine component unit (a22) containing 50 to 100 mol% of a $C_4$-$C_{18}$ aliphatic diamine component unit.

**7.** The resin composition for a reflective material according to claim 6, wherein the aliphatic diamine component unit is at least one member selected from the group consisting of a 1,9-nonanediamine unit and a 2-methyl-1,8-octane diamine unit.

**8.** The resin composition for a reflective material according to any one of claims 1 to 7, wherein the organic group X of the compound (C) is a member selected from the group consisting of methyl group, ethyl group, n-propyl group, n-octyl group, n-tetradecyl group, n-hexadecyl group, 2,4-di-t-butylphenyl group, and 2,4-di-t-pentylphenyl group.

**9.** The resin composition for a reflective material according to any one of claims 1 to 8 further comprising 5 to 50 mass% of a reinforcing material (D) relative to 100 mass% of the total of components (A), (B) and (C).

**10.** A reflector obtained by molding the resin composition for a reflective material according to any one of claims 1 to 9.

**11.** The reflector according to claim 10 which is a reflector for a light-emitting diode element.

## Patentansprüche

**1.** Harzzusammensetzung für ein reflektierendes Material, umfassend:

45 bis 80 Massen-% thermoplastisches Harz (A) mit einem Schmelzpunkt (Tm) oder einer Glasübergangstemperatur (Tg) von 250°C oder höher, gemessen mit einem dynamischen Differenzkalorimeter (DSC) gemäß JIS-K7121 gemäß der Beschreibung, wobei das thermoplastische Harz (A) aus mindestens einem Mitglied, ausgewählt aus der Gruppe, bestehend aus Polyesterharz (A1) und Polyamidharz (A2), ist;
17 bis 54,99 Massen-% Weißpigment (B); und
0,01 bis 3 Massen-% Verbindung (C), wobei die Verbindung (C) mindestens eine Art einer Verbindung, dargestellt durch die allgemeine Formel (1), ist:

Allgemeine Formel (1)

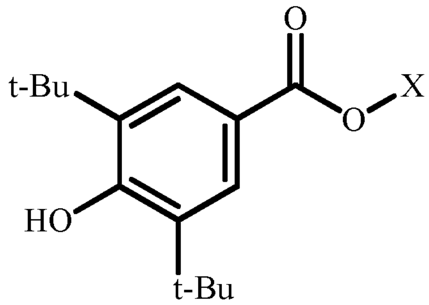

worin X für eine organische Gruppe steht,
wobei die Gesamtmenge der Komponenten (A), (B) und (C) 100 Massen-% beträgt.

**2.** Harzzusammensetzung für ein reflektierendes Material gemäß Anspruch 1, wobei die organische Gruppe X der Verbindung (C) eine substituierte oder unsubstituierte $C_1$-$C_{20}$-Alkylgruppe, eine substituierte oder unsubstituierte Cyclohexylgruppe oder eine substituierte oder unsubstituierte $C_6$-$C_{20}$-Arylgruppe ist, und
eine Substituentengruppe, die an die Alkylgruppe, Cyclohexylgruppe oder Arylgruppe gebunden ist, ein Mitglied, ausgewählt aus der Gruppe, bestehend aus einer $C_1$-$C_{12}$-Alkylgruppe, einer $C_6$-$C_{12}$-Arylgruppe, Hydroxylgruppe, Methoxygruppe und Oxadiazolgruppe, ist.

**3.** Harzzusammensetzung für ein reflektierendes Material gemäß Anspruch 1 oder 2,
wobei das Polyesterharz (A1) enthält:

Dicarbonsäure-Komponenteneinheit (a11), enthaltend 30 bis 100 Mol-% einer von Terephthalsäure abgeleiteten Dicarbonsäure-Komponenteneinheit und 0 bis 70 Mol-% einer aromatischen Dicarbonsäure-Komponenteneinheit, die von einer aromatischen Dicarbonsäure, ausgenommen Terephthalsäure, abgeleitet ist; und
Dialkohol-Komponenteneinheit (a12), enthaltend eine alicyclische $C_4$-$C_{20}$-Dialkohol-Komponenteneinheit und/oder eine aliphatische Dialkohol-Komponenteneinheit.

**4.** Harzzusammensetzung für ein reflektierendes Material gemäß Anspruch 3, wobei die alicyclische Dialkohol-Komponenteneinheit ein Cyclohexangerüst aufweist.

**5.** Harzzusammensetzung für ein reflektierendes Material gemäß Anspruch 3 oder 4, wobei die Dialkohol-Komponenteneinheit (a12) 30 bis 100 Mol-% einer Cyclohexandimethanol-Komponenteneinheit und 0 bis 70 Mol-% der aliphatischen Dialkohol-Komponenteneinheit enthält.

**6.** Harzzusammensetzung für ein reflektierendes Material gemäß Anspruch 1 oder 2,
wobei das Polyamidharz (A2) enthält:

Dicarbonsäure-Komponenteneinheit (a21), enthaltend 40 bis 100 Mol-% einer von Terephthalsäure abgeleiteten Dicarbonsäure-Komponenteneinheit und 0 bis 60 Mol-% einer aromatischen Dicarbonsäure-Komponenteneinheit, die von einer aromatischen Dicarbonsäure, ausgenommen Terephthalsäure, abgeleitet ist; und
Diamin-Komponenteneinheit (a22), enthaltend 50 bis 100 Mol-% einer aliphatischen $C_4$-$C_{18}$-Diamin-Komponenteneinheit.

**7.** Harzzusammensetzung für ein reflektierendes Material gemäß Anspruch 6,
wobei die aliphatische Diamin-Komponenteneinheit mindestens ein Mitglied, ausgewählt aus der Gruppe, bestehend aus einer 1,9-Nonandiamin-Einheit und einer 2-Methyl-1,8-octandiamin-Einheit, ist.

**8.** Harzzusammensetzung für ein reflektierendes Material gemäß einem der Ansprüche 1 bis 7, wobei die organische Gruppe X der Verbindung (C) ein Mitglied, ausgewählt aus der Gruppe, bestehend aus Methylgruppe, Ethylgruppe, n-Propylgruppe, n-Octylgruppe, n-Tetradecylgruppe, n-Hexadecylgruppe, 2,4-Di-t-butylphenylgruppe und 2,4-Di-t-pentylphenylgruppe, ist.

9. Harzzusammensetzung für ein reflektierendes Material gemäß einem der Ansprüche 1 bis 8, zusätzlich umfassend 5 bis 50 Massen-% eines Verstärkungsmaterials (D), bezogen auf 100 Massen-% der Gesamtmenge der Komponenten (A), (B) und (C).

10. Reflektor, erhalten durch Formen der Harzzusammensetzung für ein reflektierendes Material gemäß einem der Ansprüche 1 bis 9.

11. Reflektor gemäß Anspruch 10, der ein Reflektor für ein Licht-emittierendes Diodenelement ist.

## Revendications

1. Composition de résine pour un matériau réfléchissant, comprenant :

45 à 80% en masse de résine thermoplastique (A) ayant un point de fusion (Tm) ou une température de transition vitreuse (Tg) de 250 °C ou plus tel que mesuré au moyen d'un calorimètre à balayage différentiel (DSC) conformément à JIS-K7121 selon la description, la résine thermoplastique (A) étant composée d'au moins un élément choisi dans le groupe constitué de résine polyester (A1) et de résine polyamide (A2) ;
17 à 54,99 % en masse de pigment blanc (B) ; et
0,01 à 3 % en masse de composé (C), le composé (C) étant au moins un type d'un composé représenté par la formule générale (1) :

Formule générale (1)

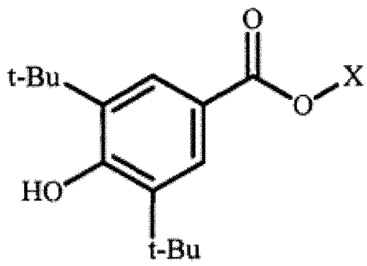

dans laquelle X représente un groupe organique,
le total des composants (A), (B) et (C) étant de 100 % en masse.

2. Composition de résine pour un matériau réfléchissant selon la revendication 1, dans laquelle le groupe organique X du composé (C) est un groupe alkyle en $C_1$-$C_{20}$ substitué ou non substitué, un groupe cyclohexyle substitué ou non substitué ou un groupe aryle en $C_6$-$C_{20}$ substitué ou non substitué, et
un groupe substituant attaché au groupe alkyle, au groupe cyclohexyle ou au groupe aryle est un élément choisi dans le groupe constitué d'un groupe alkyle en $C_1$-$C_{12}$, d'un groupe aryle en $C_6$-$C_{12}$, d'un groupe hydroxyle, d'un groupe méthoxy et d'un groupe oxadiazole.

3. Composition de résine pour un matériau réfléchissant selon la revendication 1 ou 2,
dans laquelle la résine polyester (A1) contient :

une unité de composant acide dicarboxylique (a11) contenant 30 à 100 % en moles d'une unité de composant acide dicarboxylique dérivée d'acide téréphtalique, et 0 à 70 % en moles d'une unité de composant acide dicarboxylique dérivée d'un acide dicarboxylique aromatique à l'exception de l'acide téréphtalique ; et
une unité de composant dialcool (a12) contenant une unité de composant dialcool alicyclique en $C_4$-$C_{20}$ et/ou une unité de composant dialcool aliphatique.

4. Composition de résine pour un matériau réfléchissant selon la revendication 3, dans laquelle l'unité de composant dialcool alicyclique possède un squelette de cyclohexane.

5. Composition de résine pour un matériau réfléchissant selon la revendication 3 ou 4, dans laquelle l'unité de composant dialcool (a12) contient 30 à 100 % en moles d'une unité de composant cyclohexadiméthanol et 0 à 70 % en

moles de l'unité de composant dialcool aliphatique.

6. Composition de résine pour un matériau réfléchissant selon la revendication 1 ou 2, dans laquelle la résine polyamide (A2) contient :

une unité de composant acide dicarboxylique (a21) contenant 40 à 100 % en moles d'une unité de composant acide dicarboxylique dérivée d'acide téréphtalique, et 0 à 60 % en moles d'une unité de composant acide dicarboxylique dérivée d'un acide dicarboxylique aromatique à l'exception de l'acide téréphtalique ; et
une unité de composant diamine (a22) contenant 50 à 100 % en moles d'une unité de composant diamine aliphatique en $C_4$-$C_{18}$.

7. Composition de résine pour un matériau réfléchissant selon la revendication 6, dans laquelle l'unité de composant diamine aliphatique est au moins un élément choisi dans le groupe constitué d'une unité 1,9-nonanediamine et d'une unité 2-méthyl-1,8-octane diamine.

8. Composition de résine pour un matériau réfléchissant selon l'une quelconque des revendications 1 à 7, dans laquelle le groupe organique X du composé (C) est un élément choisi dans le groupe constitué d'un groupe méthyle, d'un groupe éthyle, d'un groupe n-propyle, d'un groupe n-octyle, d'un groupe n-tétradécyle, d'un groupe n-hexadécyle, d'un groupe 2,4-di-t-butylphényle et d'un groupe 2,4-di-t-pentylphényle.

9. Composition de résine pour un matériau réfléchissant selon l'une quelconque des revendications 1 à 8, comprenant en outre 5 à 50 % en masse d'un matériau de renfort (D) par rapport à 100 % en masse du total des composants (A), (B) et (C).

10. Réflecteur obtenu par moulage de la composition de résine pour un matériau réfléchissant selon l'une quelconque des revendications 1 à 9.

11. Réflecteur selon la revendication 10 qui est un réflecteur pour un élément de diode électroluminescente.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2004075994 A
- JP 2013067786 A
- JP 2013127067 A
- US 20130158184 A1
- JP 2014134749 A